# EUROPEAN PATENT APPLICATION

(11) **EP 4 757 088 A1**
(43) Date of publication of application: **10.06.2026**
(21) Application number: 25219561.5
(22) Date of filing: 28.11.2025
(51) Int. Cl.: H02G 3/22

(54) **ARRANGEMENT FOR INSULATION OF A CABLE IN AN EMC SENSITIVE ENVIRONMENT**

(30) Priority: 09.12.2024 SE 2451251
(71) Applicant: MCT Brattberg AB, 371 92 Karlskrona (SE)
(72) Inventor: FAGERBERG, Ola, 371 92 KARLSKRONA (SE); BJÖRLENIUS, Pontus, 371 92 KARLSKRONA (SE)
(74) Representative: AWA Sweden AB

(57) **Abstract**

Disclosed herein is an arrangement (100) for insulation of a cable (200) extending through a partition wall (300) in an EMC sensitive environment, the arrangement (100) comprising a frame (110), at least one insert block (120) arranged within the frame (110) and configured to be fitted around the cable (200), a pressure applying element (130), a washer (140) arranged within the frame (110) adjacent to the at least one insert block (120), and at least one insulation element (150) comprising a first portion (151) intended to be sandwiched between the at least one insert block (120) and the washer (140) and arranged in electrical contact with the washer (140), and a second portion (152) extending from the washer (140) to the screened cable (200) and said second portion (152) is intended to be in electrical contact with the cable screen (220).

## Description

### Technical Field

The present disclosure relates to the technical field of screen protection in EMC sensitive environments, and more particularly to an arrangement for insulation of a cable extending through a partition wall in an EMC sensitive environment.

### Background

Many structures or buildings with content of high importance, for example hospitals, merchant ships, offshore platforms, airplanes, etc., have high demands on safety. These safety aspects must be considered to avoid severe damages to the content within the structure as well as people working in, or close to the area in which the structure is seated. Examples of accidents that may cause damages are fire, gas or fluid leakages, explosions, or even pest attacks. In case of such accident, the fire or leakage often spread through walls along wires, cables and/or pipes drawn therethrough.

These cable, wire or pipe transitions therefore need to be properly sealed to prevent the fire or leakage from spreading throughout the building or structure. This may be solved by permanently installing a sealed frame in the wall, providing a passage for the cables, wires, or pipes. Examples of cables, wires and pipes that may be drawn through such a frame are cables for electricity, communication, compressed air, hydraulic fluid, cooking gas, etc.

Another important aspect with cable transitions is to avoid propagating electromagnetic disturbances along the cables, wires, or pipes. Different electronic devices may be sensitive to electromagnetic disturbance caused by electromagnetic radiation, for example from other devices nearby. The disturbance may cause an unwanted interference or noise that may be induced in the circuit of an electric device, which may lead to the circuit being interrupted or obstructed, ultimately causing a decrease in the effective performance of the circuit. Therefore, cables of electric devices should be insulated to protect them from being disturbed by electromagnetic radiation from the surrounding environment.

A screened, or shielded cable are cables surrounded by a conductive layer (i.e., a cable screen) which carries the disturbances away from the cable by being grounded. However, in order to properly seal the cables drawn through a frame in a partition wall, the cable screen need often to be removed, exposing the cable to electromagnetic disturbances.

### Summary

In the light of the above, it is desired to provide alternate solutions for improving the electrical insulation of cables drawn through partition walls. These and other objects are achieved by providing an arrangement for insulation of a cable extending through a partition wall in an EMC sensitive environment having the features in the independent claims. Preferred embodiments are defined in the dependent claims.

Hence, according to a first aspect of the present invention, there is provided an arrangement for insulation of a cable extending through a partition wall in an EMC sensitive environment, wherein said cable is a screened cable connected to a ground, the arrangement comprising a frame permanently installed in a partition wall, at least one insert block arranged within the frame and configured to be fitted around the cable, wherein a portion of the cable extending through the at least one insert block is unscreened, a pressure applying element arranged within the frame to apply a pressure on the at least one insert block and seal the space within the frame, a washer arranged within the frame adjacent to the insert block, said washer is configured to maintain the at least one insert block in the intended position within the frame, and at least one insulation element for each insert block where insulation is desired. The at least one insulation element comprises a first portion intended to be sandwiched between the at least one insert block and the washer and arranged in electrical contact with the washer, and a second portion extending from the washer to the screened cable and said second portion is intended to be in electrical contact with the cable screen, and wherein said insulation element is made from an electrically conductive material.

The arrangement provides a way to electrically insulate a cable drawn through a frame in a partition wall. By arranging the at least one insulation element in electrical contact with the washer of the frame, and in electrical contact with the cable screen, a conductive path is formed through the partition wall, protecting the cable from electromagnetic disturbances.

By "screened cable" is herein meant a cable enclosed with a conductive layer for electromagnetic shielding.

By "cable screen" is herein meant the conductive layer enclosing the cable.

By "unscreened cable" is herein meant a cable without the enclosing cable screen, thus lacking the electromagnetic protection.

By "EMC sensitive environment" is herein meant an environment where electromagnetic disturbances may arise due to the presence of electrical equipment and/or systems.

The partition wall where the arrangement is installed may be a partition wall within a building or structure, for example dividing two rooms. In another example, the partition wall may be an outer wall of a building or a structure, dividing an inner environment from an outside environment. The partition wall may further be a ceiling dividing different floors. The frame permanently installed in the partition wall may be a metal frame. The frame may extend through the interior of the wall, such that a thickness of the frame corresponds to a thickness of the partition wall. The frame may have a substantially rectangular shape.

There is at least one insert block arranged within the frame. The insert block is configured to be fitted around the cable extending through the partition wall. The at least one insert block may be a plurality of insert blocks, wherein each insert block may be configured to be fitted around a cable, wire, or a pipe. The insert blocks, and the cables, wires or pipes extending therethrough are packed in layers within the frame to fill the space within the frame. Each insert block has a substantially square cross section. Moreover, the outer dimensions of an insert block are such that a predetermined number of insert blocks placed next to each other and/or on top of each other correspond to the inner dimensions of the frame to fill the space within the frame. If the number of cables, wires, or pipes is less than the number of insert blocks required to fill the space within the frame, the insert blocks may be replaced by a solid elastic rectangular block to fill the remaining spaces within the frame.

The insert block is typically made from two insert halves. Each insert block half may have a substantially rectangular body, with a first end and a second end. A semi-cylindrical groove may extend from the first end to the second end, such that a substantially circular passage is formed through the insert block when the two halves are arranged together, with the semi-cylindrical grooves facing each other. The circular passage may receive the cable, wire or pipe that should extend through the partition wall.

To seal the space within the frame, a pressure applying element is arranged within the frame, to apply a pressure on the at least one insert block. The pressure applying element may be arranged in a top part of the frame. In the example where the at least one insert block are a number of insert blocks arranged within the frame, the pressure applying element may be arranged on top of the insert blocks, or below the insert blocks. Moreover, the pressure applying element may comprise a plate arranged on each side of an elastic member and threaded shafts extending through the elastic member. The elastic member may be compressed between the plates by the shafts and nuts arranged on the shaft, such that the elastic element expands and applies a pressure on the insert blocks arranged within the frame. Other types of pressure applying elements are also available.

According to an exemplifying embodiment of the present disclosure, the at least one insert block is made of a fire resistant rubber material. This is advantageous in that rubber material is a compressible material. Therefore, when the pressure applying element applies a pressure on the at least one insert block, the insert block may be compressed and fill the space within the frame. Moreover, any air pockets between the cable, wire, or pipe and the at least one insert block may be pressed out. In the example where the at least one insert block is several insert blocks, the insert blocks may be compressed by the pressure applying device such that any gap between the insert blocks is filled. The at least one insert block may be made from another type of elastic material other than rubber, for example a rubber composite, a type of polymer or silicon.

The at least one insert block may be maintained in the intended position inside the frame by a washer. The "intended position" may herein mean a position where the at least one insert block is prevented from sliding within the frame, or sliding out from the frame. Furthermore, the intended position may be in a specific layer within the frame, as discussed above. In the example where the at least one insert block is several insert blocks, the washer may be arranged within the frame to separate the layers of insert blocks from each other, to ensure that the layers remain in their intended position within the frame, when the pressure applying element applies pressure on the insert blocks. The washer may be arranged adjacent the at least one insert block. This may for example mean that the washer is arranged in contact with one of the sides of the at least one insert block. In the example where the at least one insert block is substantially rectangular, the washer may be arranged adjacent any of the sides of the at least one insert block.

According to an exemplifying embodiment of the present disclosure, the washer is made from a sheet metal having a substantially rectangular shape and a length corresponding to an interior dimension of the frame. This is advantageous in that the washer may provide structural stability within the frame while being space efficient. The sheet metal may be made from a conductive metal, such as steel, aluminum, copper, etc.

The cable extending through the partition wall may be an electrical cable, comprising a cable screen. According to an exemplifying embodiment of the present disclosure, the cable screen comprises contraspiralling wire strands and/or a foil. This is advantageous in that the contraspiralling wire strands and/or foil provides a conductive layer around the cable. The cable screen is connected to ground, such that any electromagnetic disturbances conducted by the cable screen are led away from the cable and grounded.

Moreover, in order to properly seal the space within the frame using the pressure applying element, the portion of the cable extending through the at least one insert block may be unscreened, i.e., the cable screen may be removed from the cable on the portion of the cable extending through the at least one insert block, and thus, the partition wall. The unscreened cable may be exposed to electromagnetic disturbances, meaning that the signal and/or current passing through the unscreened cable may be interfered by an electromagnetic emission from another electronic device, for example.

Therefore, the arrangement comprises at least one insulation element, to provide a way to electrically insulate the cable through the partition wall. Each insert block comprising a cable, wire or pipe to be electrically insulated may be provided with at least one insulation element. In the example where there are several insert blocks arranged in the frame, there may be at least one insulation element provided for each insert block.

The at least one insulation element comprises a first portion intended to be sandwiched between the at least one insert block and the washer and arranged in electrical contact with the washer. The first portion may be substantially flat. Since the washer is arranged adjacent the at least one insert block, the first portion may be arranged adjacent to both the at least one insert block and the washer, when sandwiched therebetween. The first portion may be sandwiched between the at least one insert block and the washer in an airtight way. In the example where the at least one insert block has a substantially rectangular shape, and the washer is made from a sheet metal, and the first portion is substantially flat, all components may have a flat surface arranged adjacent another flat surface, such that the "stack" of components does not form any air gaps within the frame, the "stack" of components being the at least one insert block, the first portion and the washer. This is advantageous since fewer air gaps within the frame prior to applying pressure facilitates the sealing of the space within the frame. Since it is important that the space within the frame is properly sealed to prevent fire, gas leakage, fluid leakage, or similar, from spreading through the frame with the cables, wires, or pipes, and the partition wall, an efficient sealing of the space within the frame is advantageous. Moreover, the first portion of the insulation element is arranged in electrical contact with the washer. The insulation element may therefore be made from an electrically conductive material. In the example where the washer is made from a sheet metal, the electrical connection may be formed between the sheet metal of the washer and the electrically conductive material of the first portion. The first portion being sandwiched between the washer and the at least one insert block may be in physical contact with the washer (and the at least one insert block), and thereby the electrical connection may be formed.

According to an exemplifying embodiment of the present disclosure, the first portion of the at least one insulating element has a width equal to, or smaller than the width of the at least one insert block. This is advantageous in that several insert blocks having an insulation element may be arranged beside one another inside the frame, without the first portions of the insulating elements overlapping. This allows multiple cables being insulated within the same frame in a partition wall, which is beneficial in applications where there are several cables needed to be transitioned through a partition wall in an EMC sensitive environment.

Further, the at least one insulation element further comprises a second portion extending from the washer to the screened cable and arranged in electrical contact with the cable screen. The second portion may from an inside of the frame to an outside of the frame. The screened cable may be arranged on an outside of the frame, and thus the partition wall. As previously mentioned, the portion of the cable drawn through the frame may be unscreened, meaning that the cable screen is removed from the cable where the cable enters the frame inside the partition wall. Therefore, the portion of the cable that is screened may be on an outside of the frame and the partition wall. The insulation element may therefore be arranged partly inside the frame, and partly outside of the frame. The second portion may be arranged in physical contact with the cable screen, and thereby form an electrical connection. As previously mentioned, the insulation element may be formed from an electrically conductive material, and the cable screen may comprise contraspiralling wire strands and/or a foil, and thus also be made from an electrically conductive material.

According to an exemplifying embodiment of the present disclosure, the arrangement further comprises a clamp configured to clamp around the cable screen and the second portion of the at least one insulation element. The clamp may be a pipe clamp, for example. The clamp is advantageous in that may secure the screened cable and the second portion of the insulating element together. Since the screened cable is arranged on an outside of the frame and the partition wall, the screened cable may be exposed to external influence which may rearrange the cable from its original position, for example a person accidentally touching the screened cable such that it moves, or similar. Since the insulation element is partly arranged inside the sealed frame, the second portion of the insulation element is less likely to move in case someone accidentally touches it, why the screened cable may lose it's contact with the second portion, breaking the electrical connection. By installing a clamp to hold the screened cable and the second portion together, this risk is mitigated.

According to an exemplifying embodiment of the present disclosure, the second portion has a width w, and a narrower portion having a width smaller than the width w, wherein the narrower portion is configured to receive the clamp. The second portion may have a length extending from a first end to a second end, the first end being adjacent the frame, and the second end being arranged at the end of the second portion extending from the frame towards the screened cable. The narrower portion of the second portion may be arranged towards the second end of the second portion. In one example, the narrow portion is arranged towards the second end such that the second end may be shaped like a T, where the second end has the width w, and then the narrower portion is arranged after the second end along the length of the second portion towards the first end. The length of the narrower portion along the second portion may correspond to a width of the clamp, such that the clamp may be arranged around the second portion and the cable at the narrower portion. In the example where the second end has a T-shape, the clamp may be prevented from sliding along the cable, and sliding off from the second portion, since the T-shape may prevent this.

According to an exemplifying embodiment of the present disclosure, a width of the narrower portion corresponds to a diameter of the screened cable. This is advantageous in that the clamp may be efficiently arranged around the second portion of the insulating element and the screened cable. Moreover, the width w of the second portion may then exceed a diameter of the screened cable. In the example where the second end of the second portion is T-shaped, the second end may prevent the clamp from sliding along the screened cable and slide off the second portion.

According to an exemplifying embodiment of the present disclosure, the at least one insulation element is a metal bracket formed from a sheet metal. This is advantageous in that the at least one insulation element may be substantially flat. As previously discussed, the at least one insulation element may be made from an electrically conductive material, such as a sheet metal. The sheet metal may be made from steel, aluminum, copper, or an alloy, for example. A metal bracket formed from a sheet metal is also advantageous in that it may easily be formed in different shapes, for example by bending, milling, punching, etc., to achieve a desired shape. In the example where the second portion of the at least one insulating element has a narrower portion, this may be achieved by punching or milling, for example. Moreover, components made from sheet metals are typically cheap to produce.

According to an exemplifying embodiment of the present disclosure, the washer comprises a protruding flange arranged along each side of the washer from one side of the frame to the other, and wherein the at least one insert block has a length corresponding to the distance between the flanges. As previously discussed, the washer may be made from a sheet metal having a substantially rectangular shape and a length corresponding to an interior dimension of the frame. The protruding flange may therefore extend along the opposite, longer sides of the rectangular shape, and therefore comprise two protruding flanges. The washer may be arranged in the frame such that the protruding flanges extend from the frame and towards the space outside of the partition wall. The protruding flanges may therefore not be arranged in the space within the frame. The protruding flanges may comprise two rails configured to be slidably arranged along the sides of the washer, thus enclosing the edges comprised by the sides of the washer. The protruding flanges may have a height h on each side of the washer along the sides were they are arranged. The flanges may advantageously maintain the washer in its intended place within the frame, by preventing the washer from sliding out from the frame.

According to an exemplifying embodiment of the present disclosure, the second portion of the at least one insulation element is elevated in relation to the first portion, and wherein a height of the elevation corresponds to a height of the protruding flange. The at least one insulating element may therefore, from a side view, have a stepped profile. The first portion, which is sandwiched between the at least one insert block and the washer, may constitute the "lower" step in the stepped profile, while the second portion, which extends from the frame to the screened cable, constitutes the "higher" step in the stepped profile. The at least one insulating element is formed to follow the shape of the washer and the at least one insert block. Therefore, to adapt to the height difference between the washer and its protruding flange, the second portion of the at least one insulating element is elevated. The at least one insulating element may therefore lay flush against the washer and the protruding flange. This is advantageous in that the at least one insulating element may be arranged within the frame while maintaining the sealing capabilities of the frame.

According to an exemplifying embodiment of the present disclosure, a conductive path is formed between the cable screen on one side of the partition wall, through the partition wall via the at least one insulation element, to the cable screen on a second side of the partition wall, said conductive path is connected to ground. The at least one insulation element may therefore advantageously form a conductive path from the cable screen outside of the frame to the washer within the frame, and thereby electrically insulate the cable through the partition wall. The at least one insulating element replaces the cable screen where the cable screen is removed from the cable, such that the "captured" electromagnetic disturbance in the cable screen may be led away by the at least one insulating element and the washer, connected to ground. Thereby, the cable is insulated from electromagnetic disturbances along its path through the partition wall.

According to an exemplifying embodiment of the present disclosure, the conductive path is configured to act as an electromagnetic shield insulating the unscreened cable from electromagnetic disturbances by via, the conductive path, redirecting said disturbances to ground. The at least one insulation element may act as an electromagnetic shield in place of the cable screen in the partition wall. Thereby, the unscreened cable may be advantageously isolated from electromagnetic disturbances.

According to an exemplifying embodiment of the present disclosure, the electromagnetic shield is a Faraday cage. A Faraday cage is a conductive enclosure used for blocking electromagnetic fields. The conductive enclosure may within the present disclosure be the conductive path comprising the at least one insulation element and the cable screen. An external electrical field (i.e., an electromagnetic disturbance that may disturb the signal/current inside the unscreened cable) acting on the Faraday cage may cause the electric charges inside the Faraday cage (i.e., conductive material) to be distributed such that the external electrical field is cancelled out, meaning that the content enclosed by the Faraday cage, which is the unscreened cable, is not affected by the external electrical field.

In one example, the partition wall divides two spaces, wherein one side of the partition wall is an EMC sensitive environment, and the other side is not an EMC sensitive environment. Cables being led from the EMC sensitive environment, through the partition wall, and into the other environment, may be electrically insulated on the EMC sensitive side of the partition wall. In this example, the at least one insulating element may be arranged on the side of the frame facing the EMC sensitive environment, such that the second portion of the at least one insulating element extends to the screened cable in the EMC sensitive environment.

According to an exemplifying embodiment of the present disclosure, the at least one insulation element comprises a pair of insulation elements arranged on opposite sides of the insert block. In the present example, two insulating elements per insert block are arranged in the frame, on the opposite sides of the insert block. This means that the second portions of the pair of insulating elements extends from the frame on both sides of the partition wall. One insulating element may be arranged to extend from the frame into the environment on one side of the partition wall, and the other insulating element may be arranged to extend from the frame into the environment on the opposite side of the partition wall. For example, if the partition wall divides two rooms, one of the insulating elements may extend into one room, and the other insulating element may extend into the second room.

In some applications, both sides of the partition wall are EMC sensitive environments. In this case, cables drawn through the frame in the partition wall should be electrically insulated on both sides. Therefore, two insulating elements may be used, such that a conductive path is formed from one side of the partition wall, through the frame in the partition wall, and to the other side of the partition wall. This is solved by arranging two insulating elements for an insert block passing a cable through the partition wall. A first insulating element may form a conductive path between the cable screen on a first side of the partition wall, and the washer in the frame. A second insulating element may form a conductive path between the washer in the frame, and a cable screen on a second side of the partition wall. This is advantageous in that cables may be drawn through sealed frames in partition walls in EMC sensitive environments while maintaining their electrical insulation.

According to an exemplifying embodiment of the present disclosure, the pair of insulation elements are mirrored in respect of each other when installed in the arrangement. Therefore, the first portions of the pair of insulating elements may face each other when sandwiched between the at least one insert block and the washer, and the second portions of the pair of insulating elements may extend in opposite directions from the washer. This is advantageous in that the at least one insulating element may have the same shape. If more than one insulating element is needed, a user may simply add another insulating element to the arrangement without having to redesign the arrangement or order another type of component.

According to an exemplifying embodiment of the present disclosure, a gap is formed between the first portions of the pair of insulation elements arranged between the at least one insert block and the washer, the gap extending in the direction of the length of the at least one insert block. Thereby, the at least one insert block may lay against the washer between the pair of insulating elements. As previously discussed, the at least one insert block is made from an elastic material, such as rubber, and may therefore not be electrically conductive. By maintaining the physical connection between the washer and the at least one insert block, the sealing properties of the space within the frame may be maintained, ensuring that the safety requirements of the frame are met.

### Brief description of drawings

Exemplifying embodiments will now be described in more detail, with reference to the following appended drawings, in which:
Figure 1 illustrates a perspective view of an arrangement installed in a partition wall in an EMC sensitive environment according to an exemplifying embodiment of the present disclosure;
Figure 2 illustrates a perspective view of an arrangement according to an exemplifying embodiment of the present disclosure;
Figures 3a-b illustrates perspective views of an insert block, an insulation element and a washer according to an exemplifying embodiment of the present disclosure;
Figures 4a-b illustrates perspective views of an insulation element according to an exemplifying embodiment of the present disclosure.

### Detailed description

As illustrated in the figures, the size of the elements and regions may be exaggerated for illustrative purposes and, thus, are provided to illustrate the general structures of the embodiments. Like reference numerals refer to like elements throughout.

Exemplifying embodiments will now be described more fully hereinafter with reference to the accompanying figures, in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

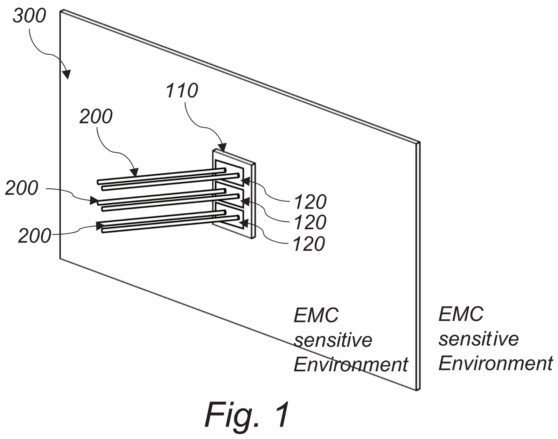

With reference to figure 1, a perspective view of an arrangement 100 installed in a partition wall 300 in an EMC sensitive environment according to an exemplifying embodiment of the present disclosure is shown. A frame 110 is arranged in the partition wall 300. The frame 110 comprises a plurality of insert blocks 120, through which cables 200 are passed. The partition wall 300 may be an outer wall or an inner wall. Further, the partition wall 300 may delimit an EMC sensitive environment from an EMC non-sensitive environment. Moreover, as shown in the present figure, the partition wall 300 may have EMC sensitive environments on both sides of the wall. The space within the frame 110 is sealed, preventing fires, gas leaks, fluid leaks, etc., from propagating through the partition wall 300. There may be more than one cable 200 installed in the frame 110. As seen in the present figure, there are several cables 200 installed in the frame 110. Furthermore, other types of conduits may be installed in the frame 110, such as different types of pipes and/or wires.

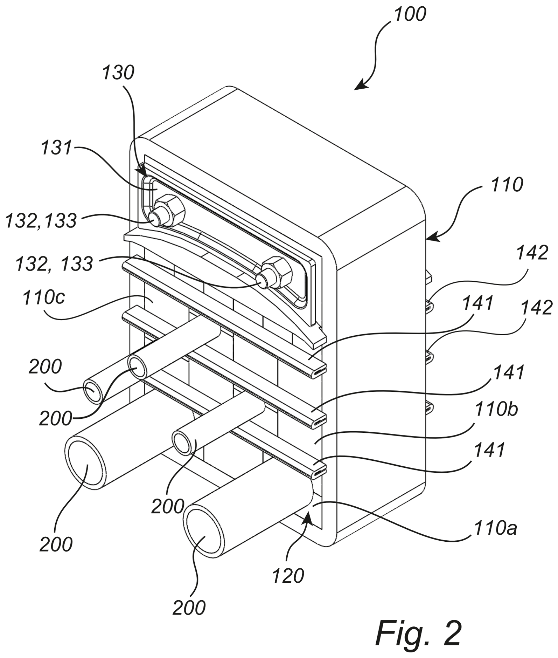

With reference to figure 2, a perspective view of an arrangement 100 according to an exemplifying embodiment of the present disclosure is shown. The arrangement 100 includes a frame 110 intended to be permanently installed in a partition wall (not shown) to provide a passage of a predetermined size in the partition wall. The cables 200, wires or pipes that need to pass through the partition wall are passed through the frame 110. In order to seal the space within the frame 110, insert blocks 120 are arranged within the frame 110, each insert block 120 is fitted around a cable 200 extending through the frame 110. The insert blocks 120 and the cables 200, wires or pipes extending through the insert blocks 150, are packed in layers 110a, 110b, 110c within the frame 110 to completely fill the space within the frame 110. The insert blocks 120 have a substantially square crosssectional shape and the outside dimensions of the insert blocks 120 are chosen such that a predetermined number of insert blocks 120 have a size corresponding to the space within the frame 110 to fill the space within the frame 110 and provide the desired sealing of the passage in the partition wall 300. The different layers 110a, 110b, 110c of insert blocks 120 are separated by washers (not shown) in order to ensure that the insert blocks 120 remain in the intended position within the frame 110. The washers 140 comprise protruding flanges 141, 142, extending from each side of the frame 110. If the number of cables 200, wires or pipes is less than the number of insert blocks 120 required to fill the space within the frame 110, the insert blocks 120 may be replaced by a solid elastic rectangular block 160 to fill the remaining space(s) within the frame 110.

After the insert blocks 120 are packed side by side in layers 110a, 110b, 110c in the intended position within the frame 110, a pressure applying device 130 is arranged in the top part of the frame 110. The top part is shown in figure 2 as the upper side of the frame 110 in a vertical direction, corresponding an orientation of the frame 110 when it is arranged in the partition wall 300. The pressure applying device 130 comprises a plate 131 arranged on each side of an elastic member (not shown) and threaded shafts 132 extending through the elastic member. The elastic member is compressed between the plates 131 by the shafts 132 and the nuts 133 arranged on the shafts 132 the elastic element expands such that a pressure is applied on the layers 110a, 110b, 110c packed within the frame 110, thereby eliminating gaps between the insert blocks 120 and sealing the space within the frame 110. Different types of pressure applying devices 130 are available and the described device may be replaced by anyone of the available devices.

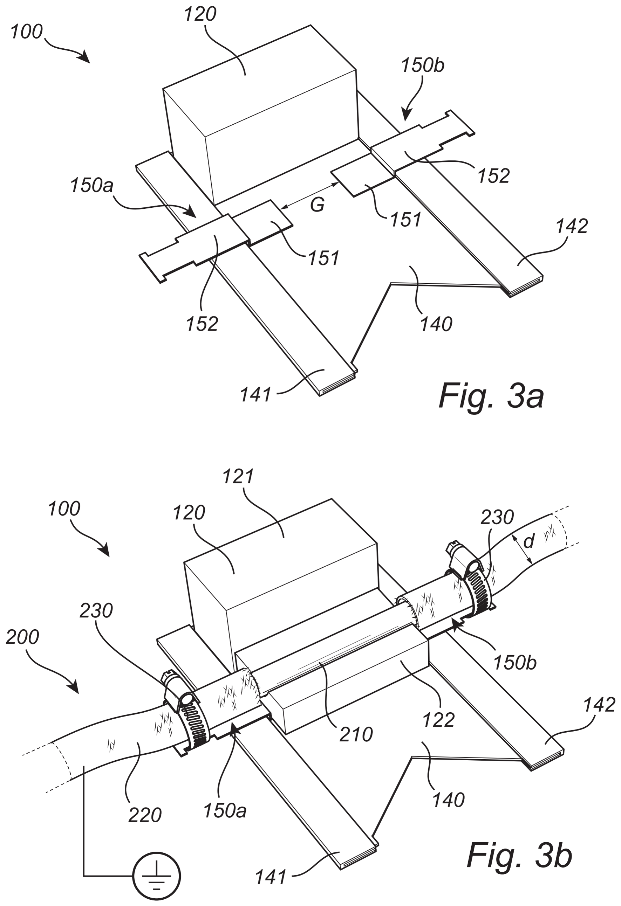

With reference to figure 3a, an insert block 120, an insulation element 150 and a washer 140 according to an exemplifying embodiment of the present disclosure is shown. The insert block 120 is shown in a position where it has been removed from its installation position on top of the at least one insulation element 150, in order to illustrate the at least one insulation element's 150 intended position in the arrangement 100. The arrangement 100 shown in figure 3a comprises a pair of insulation elements 150a, 150b. The pair of insulation elements 150a, 150b are arranged on the washer 140 in mirrored positions. The pair of insulation elements 150a, 150b are arranged such that a gap G is formed between the insulation elements 150a, 150b. When the insert block 120 is arranged on top of the insulation elements 150a, 150b, the insulation elements 150a, 150b are sandwiched between the insert block 120 and the washer 140. The space on the washer 140 formed by the gap G between the insulation elements 150a, 150b is in contact with the insert block 120. This ensures that the space within the frame 110 may be sealed properly.

Each insulation element 150a, 150b comprises a first portion 151, and a second portion 152. The first portion 151 is substantially flat and sandwiched between the insert block 120 and the washer 140. The second portion 152 is elevated in relation to the first portion 151 and extends away from the washer 140 towards the screened cable (not shown). The width of the first portion 151 is equal to or smaller than a width of the insert block 120. The washer 140 comprises a pair of flanges 141, 142 extending along the sides of the washer 140. The protruding flanges 141, 142 ensure that the insert block 120 is held in its intended position in the frame 110. AS is seen in figure 3a, the protruding flanges 141, 142 adds a height to the washer 140, preventing the insert block 120 from sliding in a horizontal (in the figure) direction on the washer 140. Moreover, the protruding flanges 141, 142 ensure that the insulating elements 150a, 150b are held in their intended position in the frame 110. The elevation of the second portion 152 of the insulating element 150a, 150b in relation to the first portion 151 corresponds to a height of the protruding flanges 141, 142. Therefore, the insulating elements 150a, 150b may be be fitted on the protruding flanges 141, 142 during installation of the arrangement 100. By arranging the insulating elements 150a, 150b on the protruding flanges 141, 142, they are prevented from sliding off the washer 140 in a horizontal direction.

With reference to figure 3b, the cable 200 is arranged in the insert block 120. The insert block 120 is comprised by two identical insert block halves 121, 122, each comprising a semi-cylindrical groove arranged in the sides of the insert halves 121, 122 facing each other. The insert block halves 121, 122 are disassembled in the present figure, to be able to properly illustrate the cable 200 installed through the insert block 120. The semi-cylindrical groove is intended to receive the cable 200. As is seen from figure 3b, a portion 210 of the cable 200 extending through the insert block 120 is unscreened. Moreover, a cable screen 220 is seen on the portion(s) of the cable 200 extending on each side of the arrangement 100. The cable screen 220 is connected to ground. The insulating elements 150a, 150b are arranged in electrical contact with the cable screen 220 on each side of the insert block 120. To maintain the electrical contact and hold the cable screen 220 and the insulating elements 150a, 150b together, a clamp 230 is installed for each insulating element 150a, 150b. The clamp 230 is arranged around the insulating elements 150a, 150b and the screened cable 220. The width of the second portion 152 of the insulating elements 150a, 150b corresponds to a diameter d of the screened cable 200. Thereby, the insulating elements 150a, 150b, are also connected to ground, and may continue to lead away any electromagnetic disturbances from the cable 200, even when the cable 200 is unscreened 210 through the insert block 120.

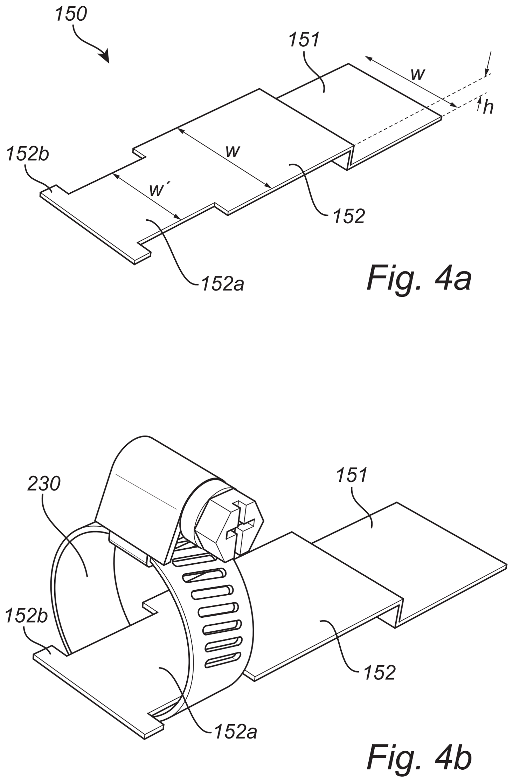

With reference to figure 4a, an insulation element 150 according to an exemplifying embodiment of the present disclosure is shown. The first portion 151 of the insulating element 150 is substantially flat and has a rectangular shape, with a width w. The second portion 152 has a width w and a portion 152a with a narrower width w'. One end 152b of the second portion 152, opposite to the end of the second portion 152 facing the first portion 151, forms a T shape with the portion 152a having the narrower width w'. Further, the second portion 152 is elevated with a height h in relation to the first portion 151. With reference to figure 4b, the clamp 230 is shown arranged on the insulating element 150. The clamp 230 is arranged in the portion 152a with a narrower width w' in the second portion 152 of the insulating element 150. The T shape formed by the end 152b of the second portion 152 and the narrower portion 152a holds the clamp 230 in its intended position on the insulating element 150, and prevents the clamp 230 from sliding off the insulating element 150. The clamp 230 may be a standard type of pipe clamp, however other types of clamps 230 are also possible.

Although features and elements are described above in particular combinations, each feature or element can be used alone without the other features and elements or in various combinations with or without other features or elements.

Additionally, variations to the disclosed embodiments can be understood and effected by the skilled person in practicing the claimed invention, from a study of the figures, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. An arrangement (100) for insulation of a cable (200) extending through a partition wall (300) in an EMC sensitive environment, wherein said cable (200) is a screened cable (220) connected to a ground, the arrangement (100) comprising:
a frame (110) permanently installed in a partition wall (300);
at least one insert block (120) arranged within the frame (110) and configured to be fitted around the cable (200), wherein a portion (210) of the cable extending through the at least one insert block (120) is unscreened;
a pressure applying element (130) arranged within the frame (110) to apply a pressure on the at least one insert block (120) and seal the space within the frame (110);
a washer (140) arranged within the frame (110) adjacent to the at least one insert block (120), said washer (140) is configured to maintain the at least one insert block (120) in the intended position within the frame (110), **characterized in that** said arrangement furthermore comprises
at least one insulation element (150) for each insert block (120) where insulation is desired, the at least one insulation element (150) comprising:
a first portion (151) intended to be sandwiched between the at least one insert block (120) and the washer (140) and arranged in electrical contact with the washer (140); and
a second portion (152) extending from the washer (140) to the screened cable (200) and said second portion (152) is intended to be in electrical contact with the cable screen (220); and
wherein said insulation element is made from an electrically conductive material.

2. Arrangement (100) according to claim 1, wherein the at least one insulation element (150) comprises a pair of insulation elements (150a, 150b) arranged on opposite sides of the at least one insert block (120).

3. Arrangement (100) according to claim 1 or 2, wherein the at least one insulation element (150) is a metal bracket formed from a sheet metal.

4. Arrangement (100) according to any one of the preceding claims, wherein the washer (140) is made from a sheet metal having a substantially rectangular shape and a length corresponding to an interior dimension of the frame (110).

5. Arrangement (100) according to claim 4, wherein the washer (140) comprises a protruding flange (141, 142) arranged along each side of the washer (140) from one side of the frame (110) to the other, and wherein the at least one insert block (120) has a length corresponding to the distance between the flanges (141, 142).

6. Arrangement (100) according to claim 5, wherein the second portion (152) of the at least one insulation element (150) is elevated in relation to the first portion (151), and wherein a height of the elevation corresponds to a height of the protruding flange (141, 142).

7. Arrangement (100) according to claim 2 and 6, wherein a gap (G) is formed between the first portions (151) of the pair of insulation elements (150a, 150b) arranged between the at least one insert block (120) and the washer (140), the gap (G) extending in the direction of the length of the at least one insert block (150).

8. Arrangement (100) according to any one of claims 2 to 7, wherein the pair of insulation elements (150a, 150b) are mirrored in respect of each other when installed in the arrangement (100).

9. Arrangement (100) according to any one of the preceding claims, further comprising a clamp (230) configured to clamp around the cable screen (220) and the second portion (152) of the at least one insulation element (150).

10. Arrangement (100) according to claim 9, wherein the second portion (152) has a width w, and a narrower portion (152a) having a width smaller than the width w, wherein the narrower portion is configured to receive the clamp (230), and wherein a width of the narrower portion corresponds to a diameter (d) of the screened cable (220).

11. Arrangement (100) according to any one of the preceding claims, wherein the first portion (151) of the at least one insulation element (150) has a width equal to, or smaller than the width of the at least one insert block (120).

12. Arrangement (100) according to any one of the preceding claims, wherein the cable screen (220) comprises contraspiralling wire strands and/or a foil.

13. Arrangement (100) according to claim 2, wherein a conductive path is formed between the cable screen on one side of the partition wall, through the partition wall via the insulation elements, to the cable screen on a second side of the partition wall, said conductive path is connected to ground.

14. Arrangement (100) according to claim 13, wherein the conductive path is configured to act as an electromagnetic shield insulating the unscreened cable from electromagnetic disturbances by via, the conductive path, redirecting said disturbances to ground.

15. Arrangement (100) according to claim 14, wherein the electromagnetic shield is a Faraday cage.
